# EUROPEAN PATENT APPLICATION

(11) **EP 4 769 963 A1**
(43) Date of publication of application: **01.07.2026**
(21) Application number: 25227130.9
(22) Date of filing: 24.12.2025
(51) Int. Cl.: H04B 3/54

(54) **ACTIVE INDUCTIVE IMPEDANCE ENHANCEMENT CIRCUIT APPLIED TO POWER LINE PATH**

(30) Priority: 27.12.2024 TW 113151380
(71) Applicant: HK Oceancomm Technology Co., Limited, Hong Kong (HK)
(72) Inventor: LI, HSIN-HSIEN, Zhubei City (TW); ZHANG, YONG-LIN, Zhubei City (TW)
(74) Representative: Lang, Christian

(57) **Abstract**

The present invention provides an active inductive impedance enhancement circuit applied to a power line path. It utilizes a closed-loop control technique to detect residual high-frequency signals on the power line and generates a compensation current injected into the secondary side of the main inductor accordingly. The invention actively suppresses high-frequency current flowing through the main inductor, thereby significantly enhancing its impedance against high-frequency noise.

## Description

### FIELD OF THE INVENTION

The present invention relates to a circuit device and a method for improving signal isolation quality in Power Line Communication (PLC) or for enhancing inductor performance in a high-current filter.

### DESCRIPTION OF RELATED ART

In applications of Power Line Communication (PLC) or power filtering, an isolator (typically a low-pass filter) is often required to partition the power line into a power consumption side and a transmission side. This serves to block the influence of time-varying noise and impedance from the power consumption side on the communication frequency bands. However, when the isolator is located in a high-current path (such as a utility meter entry), conventional passive isolators often require bulky and expensive magnetic cores to avoid magnetic saturation. The large volume and high cost of such inductors consequently limit the widespread application of filters on power line.

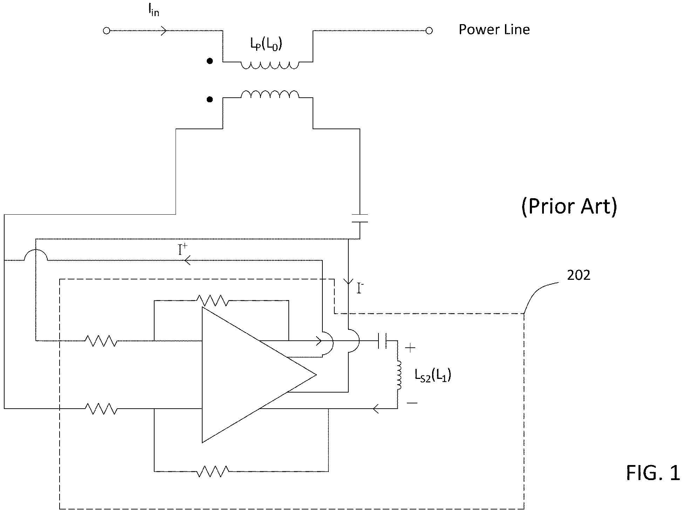

Prior art has proposed utilizing active circuits to enhance equivalent inductance values; however, these methods still suffer from certain drawbacks. FIG. 1 illustrates one such circuit in the prior art. This circuit utilizes a reference inductor L_{S2} to replicate a portion or a specific ratio of the current, generating opposing compensation current (I⁺, I⁻) to suppress the current Iᵢₙ flowing through the primary inductor L_{P}. This thereby achieves or generates a current suppression effect equivalent to that of a large inductor. However, this approach presents two primary issues: first, under certain external circuit combinations, using an amplifier as the current generator 202 tends to cause oscillation in the entire loop. Consequently, a trade-off must be made between performance and stability, making it difficult to achieve an inductance enhancement of more than 10 times. Second, the frequency response of the reference inductor L_{S2} must closely match that of the primary inductor L_{P}; otherwise, it is difficult to achieve the ideal inductance enhancement effect for the primary inductor L_{P} across a wide frequency range.

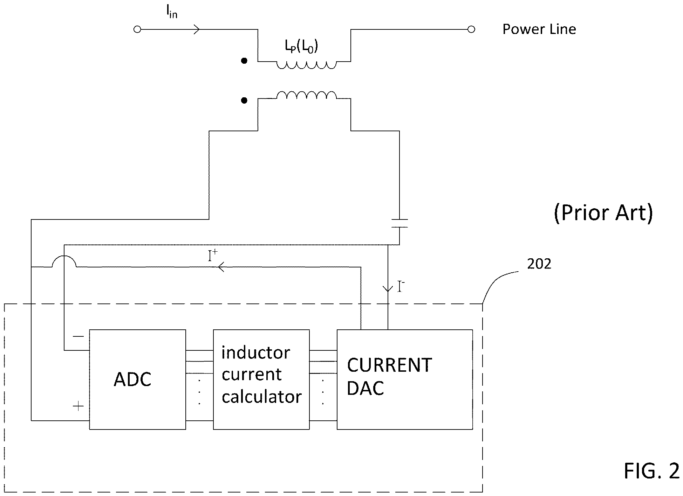

The circuit architecture and method illustrated in FIG. 2 can circumvent the issues associated with the circuit type of FIG. 1; specifically, there is no oscillation problem to resolve, and no additional reference inductor is required. In the circuit architecture of FIG. 2, the current generator 202 is primarily comprised of an Analog-to-Digital Converter (ADC), a digitized inductor current calculator, and a current Digital-to-Analog Converter (DAC). This prior art technique utilizes the DAC in conjunction with a predetermined algorithm to generate opposing compensation currents (I⁺, I⁻). However, if the method of the prior art shown in FIG. 2 is employed in isolation without additional monitoring circuits, it is difficult to output the correct opposing compensation current (I⁺, I⁻) at the precise timing required to obtain a higher equivalent main inductance value L. The built-in algorithm performs calculations based on a predetermined, fixed inductance model. Consequently, once there is a change in ambient temperature or when the Alternating Current (AC) flowing through the primary inductor L_{P} becomes large (causing slight magnetic saturation which alters the inductance value), the system fails to accurately output the opposing compensation current (I⁺, I⁻). As a result, the suppression effect on the primary inductor L_{P} deteriorates, as the system is unable to calibrate for the impact of environmental changes in real-time.

### SUMMARY OF THE INVENTION

To address the issue where open-loop systems (as seen in the prior art of FIGS. 1 and 2) fail to correct errors in real-time, the present invention provides an inductance enhancement system featuring closed-loop control. The present invention incorporates a current measurement and monitoring unit within the high-current path to detect, in real-time, a residual high-frequency current flowing through the primary inductor or an induced voltage thereof. By feeding this data back to a decision and calculation unit, the compensation current output by the DAC is dynamically adjusted, thereby establishing a negative feedback control loop. This method effectively eliminates errors caused by temperature variations, magnetic saturation, or component aging. Consequently, it ensures that the system can stably enhance the equivalent inductance value by a factor of 10 or more, while maintaining optimal filtering performance.

### BRIEF DESCRIPTION OF DRAWINGS

FIGS. 1 and 2 illustrate prior art techniques used for improving PLC communication.
FIGS. 3 through 6B illustrate an embodiment of the present invention.
FIG. 7A illustrates a prior art technique used for improving PLC communication.
FIGS. 7B through 9 illustrate an embodiment of the present invention.

### DETAILED DESCRIPTION OF THE INVENTION

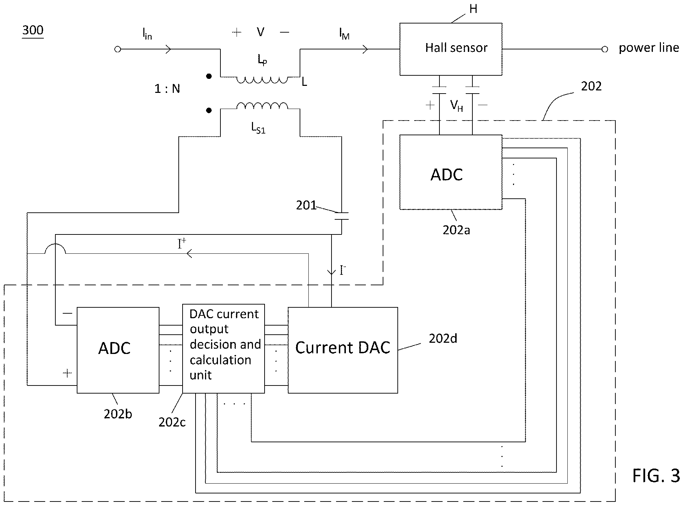

According to an embodiment of the present invention, by incorporating a system and method utilizing a monitoring circuit, the present invention can stably increase an inductance value by a factor of 10 or more. FIG. 3 illustrates an inductance boosting circuit 300 having a function of directly measuring current. The circuit 300 comprises a primary inductor L_{P} (having an inductance value L) connected to a power line, a secondary inductor L_{S1}, and a current generator 202. The primary inductor L_{P} is connected in series to the power line and is coupled to the secondary inductor L_{S1} with a turns ratio of 1:N. The current generator 202 includes Analog-to-Digital Converters (ADCs) 202a and 202b, a DAC current output decision and calculation unit 202c, and a Current Digital-to-Analog Converter (Current DAC) 202d. The current generator 202 is coupled to the secondary inductor LS1 via an isolation capacitor 201. In addition, to establish closed-loop control, in the present embodiment, a current measuring device is connected in series subsequent to the primary inductor L_{P}. In this embodiment, the current measuring device is connected in series subsequent to the main inductor LP. In the present embodiment, the current measuring device is implemented by a Hall sensor H. The Hall sensor H is configured to sense the power current after low-frequency components have been filtered out, retaining and outputting only a high-frequency current I_{M} in a communication frequency band to the ADC 202a. In other words, an induced voltage VH output by the Hall sensor H is transmitted to the ADC 202a for digital sampling, wherein the signal represents a magnitude of a residual high-frequency current I_{M} flowing through the primary inductor. To precisely process signals, the high-frequency current I_{M} output by the Hall sensor H is transmitted to the ADC 202a for digital sampling, while a voltage signal V across the primary inductor LP is read and detected by the independent ADC 202b. In the present embodiment, the current measuring device (Hall sensor H) is disposed in a high-current path. The current measuring device is configured to measure a high-frequency current IM retained after a low-frequency current is filtered out, thereby measuring a magnitude of the current in a communication frequency band to serve as a basis for increasing or decreasing a DAC current (I⁺, I⁻)or for adjusting algorithm parameters. Consequently, the conventional open-loop enhancement system shown in FIG. 2 is provided with a closed-loop control system. Thus, the circuit of the present invention prevents error accumulation, thereby ensuring that the opposing compensation current (I⁺, I⁻) provided by the Current DAC 202d effectively suppress a current lin flowing through the primary inductor L_{P} (specifically in the communication frequency band, without affecting the low-frequency power supply current). Since the purpose of the entire closed-loop control is to reduce the current Iᵢₙ flowing through the primary inductor L_{P}, the circuit 300 detects changes in the current lin of the primary inductor LP (by reading and sensing IM via the Hall sensor H). Then, the circuit 300 commands the Current DAC 202d to adjust the magnitude and direction of the output opposing compensation current I⁺ and I⁻ to cancel out noise on the primary inductor L_{P}. In other words, the output of the DAC in the circuit 300 can be adjusted according to changes in the primary inductor L_{P} current lin. The Hall sensor H serves as an error sensing unit. The compensation currents I⁺ and I⁻ are injected into the secondary inductor L_{S1}. Through magnetic coupling, a magnetic flux opposite to the residual high-frequency signal in the communication frequency band is generated in the primary inductor L_{P}, thereby actively suppressing the high-frequency current lin flowing through the primary inductor L_{P}.

After the ADC 202b detects a voltage signal V across the primary inductor L_{P}, and the ADC 202a simultaneously detects a residual high-frequency current I_{M} from the Hall sensor H, the DAC current output decision and calculation unit 202c calculates and adjusts the output currents I⁺ and I⁻ of the Current DAC 202d based on these two sets of data. Given that an inductance value L of the primary inductor L_{P} is known, after each detecting of the voltage signal V by the ADC 202b, the current of the Current DAC 202d is adjusted according to the following equation: I(T+1)=I(T)+dI=I(T)+C×(V(T) ×dT/L)+ I_{M}; wherein I_{M} represents the residual high-frequency current signal flowing through the primary inductor L_{P} as filtered by the Hall sensor H and measured by the ADC 202a; and dT represents a sampling period or a time delay from a sampling input of the ADC 202b to a completion of a current output by the Current DAC 202d. A direction of I_{M} relative to the output current of the Current DAC 202d (labeled as I⁺ in the figure) may be in the same direction or in an opposite direction. If they are in the same direction, it indicates that a current intensity of the compensation current is insufficient and fails to fully cancel noise. If they are in the opposite direction, it indicates that the compensation current is excessive (i.e., over-compensation). In both cases, the output of the Current DAC 202d requires adjustment. An initial value of the constant C is set to 1. Since the inductance value L of the primary inductor L_{P} may gradually change due to temperature, signal frequency, and a magnitude of a power current, or because measurement errors may exist in the current I_{M}, the constant C is corrected in a progressive manner. If I_{M} is in the same direction, the value of the constant C is adjusted to increase slightly; conversely, if I_{M} is in the opposite direction, the value of the constant C is adjusted to decrease slightly. By fine-tuning in this manner, I_{M} is maintained at a relatively small value, thereby achieving a relatively large equivalent inductance or an improved filtering effect (i.e., realizing a greater equivalent inductance or a superior filtering effect).

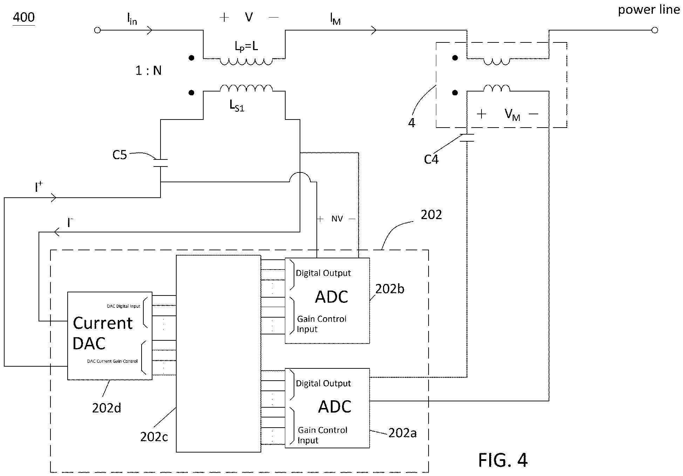

In addition to the method of directly measuring current, another lower-cost solution is to connect a small inductor (a primary winding of a transformer 4) in series within a power current path, and to utilize an induced voltage V_{M}, which is generated by variations in the current sensed thereby, as a basis for adjustment. FIG. 4 illustrates another inductance enhancement circuit having a current measurement function, wherein the circuit 400 implements closed-loop control via the induced voltage V_{M}.

The coupling circuit is implemented by a transformer 4 in series connection with a capacitor C4. The transformer 4 is adapted to increase a voltage level, and the capacitor C4 serves to isolate the circuit from low-frequency or DC power currents. The induced voltage V_{M} is generated by induction via a rate of change of a current flowing through the power line, and the transformer 4 can be regarded as an error sensing unit. In the current generator 202 of the present embodiment, the ADC 202b is coupled to a secondary inductor L_{S1} of the primary inductor L_{P} or a related coupling loop, and is configured to detect a voltage signal NV that is proportional to a voltage across the primary inductor L_{P}. The ADC 202a is coupled to a secondary inductor of the transformer 4 and is configured to detect the induced voltage V_{M}. The DAC current output decision and calculation unit 202c receives the reference voltage NV from the ADC 202b and the induced voltage V_{M} from the ADC 202a, and performs algorithmic calculations. Based on a calculation result from the DAC current output decision and calculation unit 202c, the Current DAC 202d generates a corresponding compensation current I⁺ and injects the same into the secondary inductor L_{S1}, thereby cancelling the high-frequency current Iᵢₙ flowing through the primary inductor L_{P}. Additionally, the secondary inductor L_{S1} is connected in series with a capacitor C5 to isolate low-frequency current signals induced from the primary inductor L_{P}.

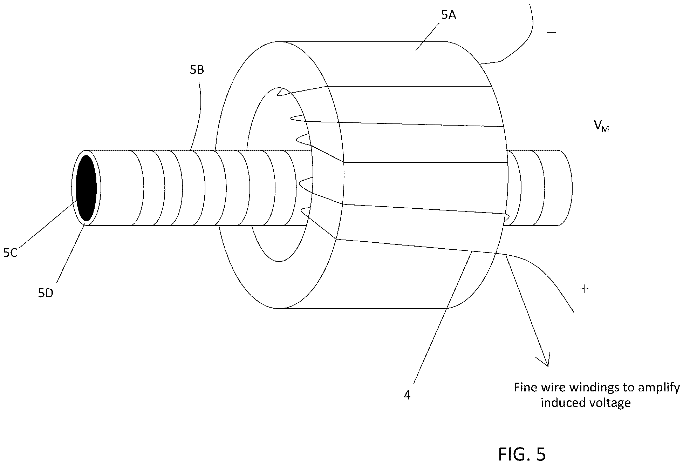

Please refer to FIG. 5. FIG. 5 illustrates an architecture of the transformer 4. The transformer 4 may be implemented using a magnetic core 5A wound with fine conductive wires and a power current copper wire 5B passing therethrough. Specifically, the magnetic core 5A is sleeved around the power current copper wire 5B. The power current copper wire 5B comprises an inner copper core 5C and is covered by an outer insulation layer 5D. The transformer 4 includes a plurality of turns of fine wire windings configured to amplify an induced voltage V_{M}. This configuration provides a cost-effective solution while amplifying the sensing voltage, which is advantageous for sensing low currents. As described above, this method of modulating current differs from techniques that directly measure current. In a simplified embodiment, the compensation current I⁺ output by the Current DAC 202d is adjusted based on the following equation: I(T+1)=I(T)+dI= I(T)+C×(V(T) ×dT/L)+C1×V_{M}(T) ×dT, wherein C1 is a constant associated with an inductance value of a small inductor (specifically, a primary side inductance of the transformer 4) and an amplification ratio. The initial value of C is also set to 1. During a convergence process, it is determined whether V_{M}(T) and V(T) are in the same direction. That is, the directionality o V_{M}(T) and V(T) is compared during the convergence process; if both are positive values or both are negative values, this represents the same direction, whereas the converse represents opposite directions. If they are in the same direction, the value of C is slightly increased; conversely, if they are in opposite directions, the value of C is slightly decreased. During this process, an absolute value of the induced voltage V_{M} decreases. Maintaining V_{M} at a relatively small value indicates that a current flowing therethrough is relatively small, which implies a better filtering effect or a larger equivalent inductance value of a primary inductor L_{P}. To achieve convergence to a lower current, the value of C1 may also be adjusted appropriately. By utilizing an interactive adjustment of both C and C1, a more ideal convergence effect can be achieved. This process may employ a more complex algorithm for convergence to ensure the stability and efficiency of the system.

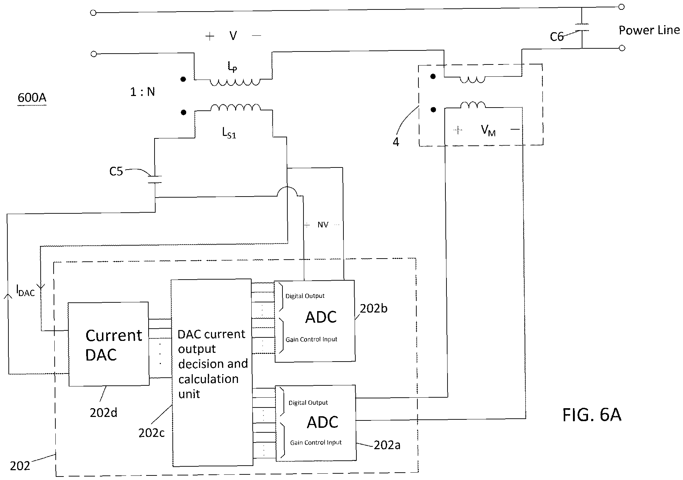

In practical applications of filter circuits, there are generally several configuration methods. FIG. 6A illustrates a simplest example of a single-ended filter. This configuration filters only a single-ended power line; however, it provides an impedance enhancement effect regardless of whether the current flowing through the inductor is a differential mode current or a common mode current. In the present embodiment, a transformer 4 is disposed at a rear end (or downstream side) of a primary inductor L_{P} of a circuit 600A. The transformer 4 is configured to sense high-frequency signal errors on the line and output an induced voltage V_{M}. The operation of the current generator 202 is the same as the principle described in FIG. 4. At an output end of the circuit 600A, a filter capacitor C6 is connected across the power lines. In this embodiment, a compensation current I_{DAC} is injected into a secondary side inductor L_{S1} via a capacitor C5. The filter capacitor C6 is connected in parallel at the power line output end and constitutes an LC low-pass filter circuit together with the primary inductor L_{P}.

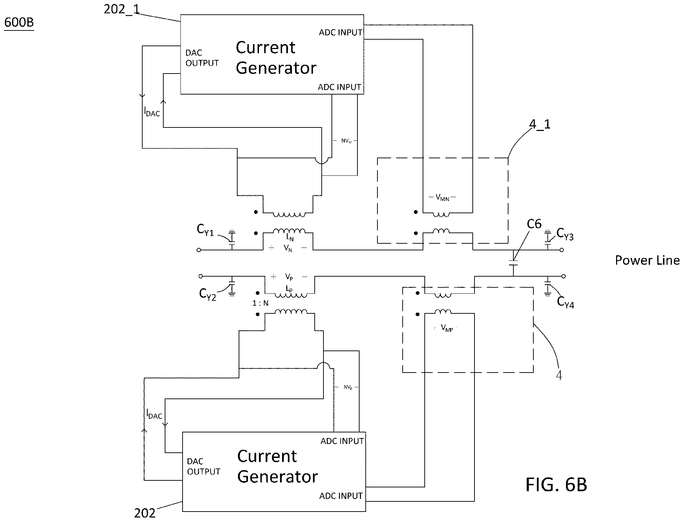

In another embodiment, the circuit 600B shown in FIG. 6B illustrates an architecture of a symmetric filter for two power lines. Unlike the single-ended configuration of FIG. 6A, the present embodiment disposes independent active impedance enhancement circuits on both power lines. Two sets of inductors (L_{P} and L_{N}) are respectively enhanced, enabling the simultaneous filtering of both differential-mode and common-mode noise. An upper loop is controlled by a current generator 202_1, which receives a proportional voltage of a reference voltage V_{N} from the upper primary inductor L_{N} and an induced voltage V_{MN} from a transformer 4_1, and outputs a compensation current I_{DAC} for injection into the upper loop. A lower loop is controlled by a current generator 202, which receives a proportional voltage of a reference voltage signal V_{P} from the lower primary inductor L_{P} and an induced voltage V_{MP} from a transformer 4, and outputs a compensation current I_{DAC} for injection into the lower loop. Both the current generator 202_1 and the current generator 202 comprise dual ADC input terminals and are configured to independently execute closed-loop control algorithms. This ensures that, regardless of variations in the phase and amplitude of noise on the two power lines, the circuit 600B performs precise real-time compensation based on the status of the respective line. In addition, the circuit 600B is further provided with Y-capacitors C_{Y1}, C_{Y2}, C_{Y3} and C_{Y4} connected between the power lines and a ground terminal. These capacitors provide low-impedance paths for bypassing common-mode noise to the ground, operating in coordination with the enhanced main inductors to further improve overall common-mode noise suppression performance.

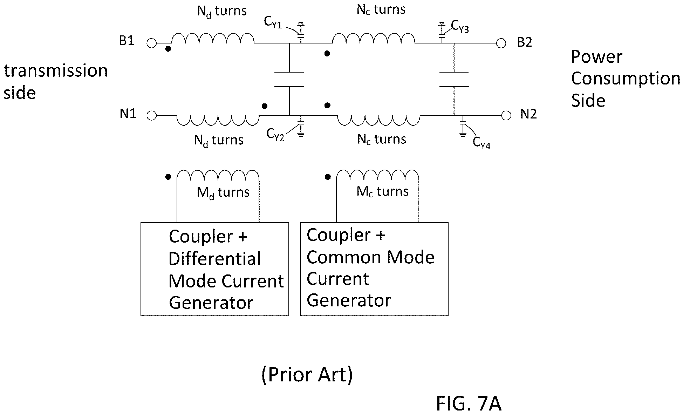

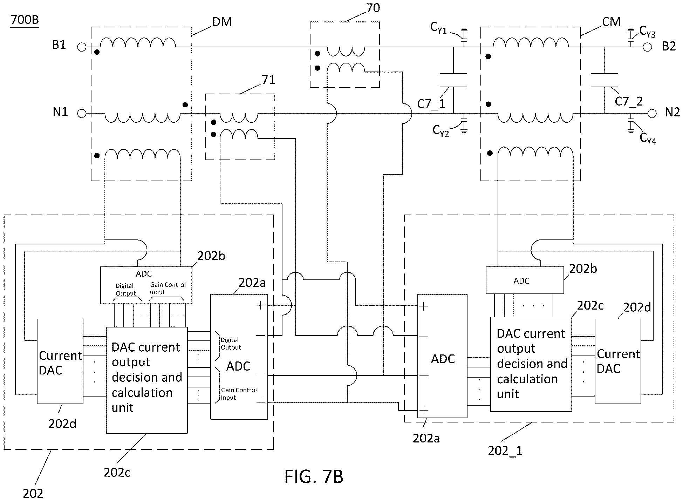

If an overall filter design prioritizes common-mode noise filtering, a differential-mode inductor is typically employed in conjunction with a separate common-mode inductor to implement the complete or partial filter design, as illustrated in FIG. 7A (Prior Art). In contrast, the architecture achieved by the present invention is illustrated in FIG. 7B. A circuit 700B is coupled between a power transmission side (power input terminals B1, N1) and a power consumption side (power output terminals B2, N2). The circuit 700B comprises a differential-mode filter circuit on a left side and a common-mode filter circuit on a right side, which are independently controlled by two sets of current generators 202 and 202_1. The differential-mode filter circuit comprises a differential-mode inductor DM, a capacitor C7_1, and the current generator 202. The common-mode filter circuit comprises a common-mode inductor CM, a capacitor C7_2, and the current generator 202_1. In this embodiment, small inductors (or a coupling structure of transformers 70 and 71) are provided on both power lines. Voltage sensing signals derived therefrom are simultaneously distributed to the two current generators 202 and 202_1 for signal processing and compensation. Specifically, regarding the differential-mode filter circuit on the left side, the current generator 202 is configured to sense a differential-mode current by performing voltage subtraction, thereby controlling the enhancement of the differential-mode inductor. Conversely, regarding the common-mode filter circuit on the right side, the current generator 202_1 is configured to sense a common-mode current by performing voltage addition, thereby controlling the enhancement of the common-mode inductor. In addition, the circuit 700B further includes Y-capacitors C_{Y1} and C_{Y2} disposed between the differential mode inductor and the common mode inductor, as well as Y-capacitors C_{Y3} and C_{Y4} disposed at a rear end of the common mode inductor (or the Y-capacitors C_{Y3} and C_{Y4} are disposed at an output side of the common mode inductor CM). Each of these Y-capacitors is connected between the power line and a ground terminal, providing low-impedance paths for discharging common-mode noise to the ground, and operating in coordination with the actively enhanced common mode inductor to further improve overall noise suppression performance.

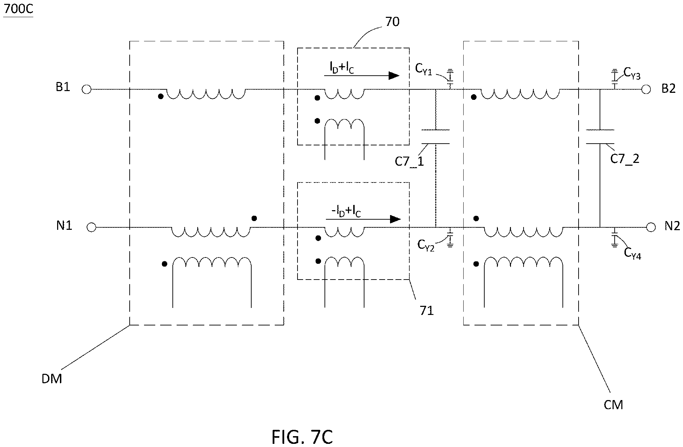

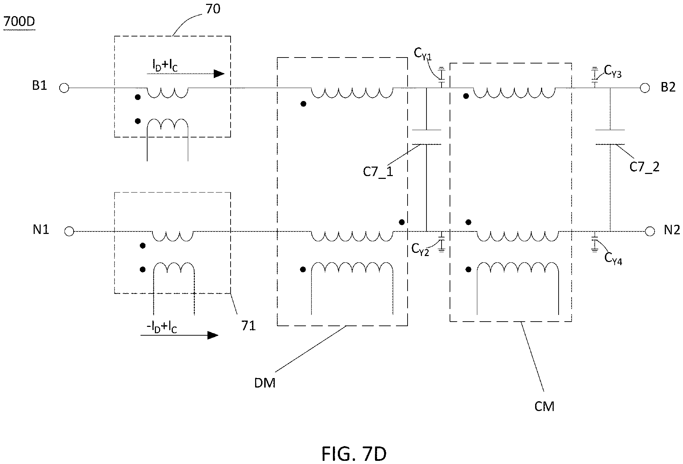

Referring to FIG. 7C, the circuit 700C comprises a differential mode inductor DM, transformers 70 and 71, a capacitor C7_1, a common mode inductor CM, and a capacitor C7_2. The small inductors (the primary side inductors of the transformers 70 and 71) are disposed on the side of the differential mode inductor DM to accurately measure the differential mode current flowing through the differential mode inductor DM, thereby avoiding a failure to measure the differential mode current flowing through the capacitor C7_1. Wherein, the primary side inductor of the transformer 70 is configured to sense a current (I_{D} + Ic) of an upper power line; the primary side inductor of the transformer 71 is configured to sense a current (-I_{D} + Ic) of a lower power line. The transformers 70 and 71 may be regarded as an error sensing unit. As shown in FIG. 7D, the circuit 700D of the present embodiment similarly comprises a two-stage filtering architecture for differential mode and common mode; however, the transformers 70 and 71 thereof are disposed at a foremost end of the circuit 700D.

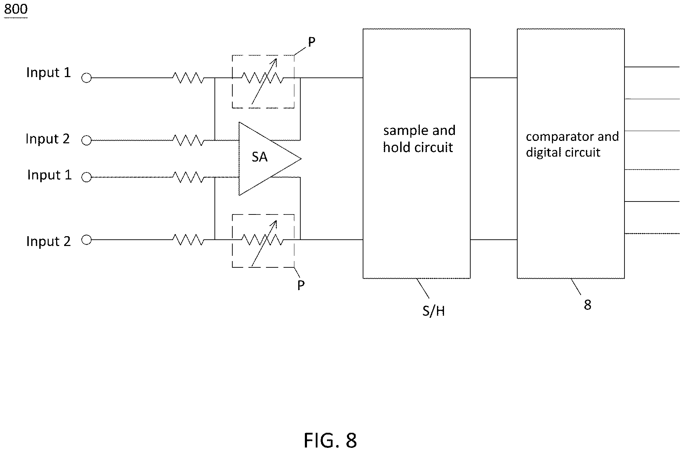

The circuits of FIG. 7C and FIG. 7D indicate that the ADC for detecting voltages of the small inductors requires four input terminals. In one embodiment, as shown in FIG. 8, a circuit 800 illustrates an internal front-end circuit architecture of the ADC 202b of the present invention. To facilitate the differential mode and common mode signal separation function required by the aforementioned FIG. 7B to FIG. 7D, the input terminals (two sets of Input 1 and Input 2) of the ADC of the present invention are not merely voltage detecting terminals but integrate an analog operational amplifier circuit, wherein the input terminals of the ADC are connected to the aforementioned transformers 70 and 71. The circuit thereof may typically be implemented by a summing amplifier SA, which is still regarded as a part of the ADC, except that the summing amplifier SA is expanded from two input terminals to four input terminals (the two sets of Input 1 and Input 2). That is, in the present embodiment, the summing amplifier SA, a sample and hold circuit S/H, and a comparator and digital circuit 8 are connected in series to constitute the ADC 202b. In addition, a resistance value of a feedback resistor P on a feedback loop of the summing amplifier SA is adjustable by a DAC decision and calculation unit 202c to control an amplification value (gain), thereby increasing a voltage detection range; wherein the feedback resistor P is coupled between an output terminal and an inverting input terminal of the summing amplifier SA. In addition, in both the circuit 700C and the circuit 700D, Y-capacitors C_{Y1} and C_{Y2} are disposed between the differential mode inductor DM and the common mode inductor CM, and Y-capacitors C_{Y3} and C_{Y4} are disposed at an output side of the common mode inductor CM. Each of these Y-capacitors is connected between the power line and a ground terminal for bypassing common-mode noise, thereby constituting a complete EMI suppression scheme in conjunction with the downstream common-mode filtering circuit.

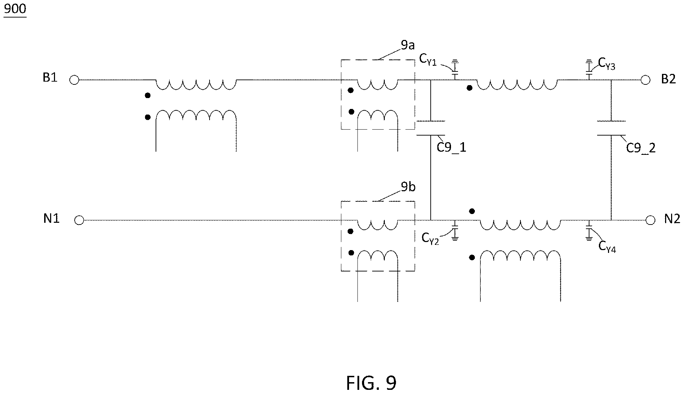

To reduce the cost of the differential mode inductor, the configuration shown in FIG. 9 may be adopted, which offers advantages in both cost and size. A differential mode filter on the left side of a circuit 900 comprises a single-winding inductor disposed in series only on an upper power line (between B1 and B2). This design utilizes an active enhancement technology of the present invention to effectively suppress differential mode noise even with the single-winding configuration. An upper transformer 9a and a lower transformer 9b are respectively connected in series to the two power lines and are disposed prior to a capacitor C9_1 to ensure that a complete error signal, which has not been shunted by the capacitor, is captured; wherein the transformers 9a and 9b may be regarded as an error sensing unit. The capacitor C9_1 is coupled between the two lines to filter out the differential mode noise. A right side of the circuit 900 is connected to a standard dual-winding common mode inductor and a capacitor C9_2, and is finally connected to power output terminals (B2, N2). The circuit 900 is also provided with Y-capacitors connected between the power lines and a ground terminal, including Y-capacitors C_{Y1} and C_{Y2} disposed between the differential mode and common mode filtering stages, and Y-capacitors C_{Y3} and C_{Y4} disposed at an output side of the common mode inductor. These Y-capacitors provide discharge paths for common-mode noise, ensuring that excellent common-mode noise suppression capability is maintained while the structure of the differential mode inductor is simplified

## Claims

1. An active inductive impedance enhancement circuit applied to a power line path, comprising:
a primary inductor disposed in series on the power line path and configured to carry a power current;
a secondary side inductor magnetically coupled to the primary inductor and having a turns ratio;
an error sensing unit disposed on the power line path and configured to detect a residual high-frequency signal of a communication frequency band on the power line path; and
a current generator serving as a closed-loop control unit and electrically connected to the error sensing unit and the secondary side inductor, wherein the current generator generates a compensation current according to a calculation result of a voltage state of the primary inductor and the residual high-frequency signal on the power line path;
wherein the compensation current is injected into the secondary side inductor to generate a magnetic flux in the primary inductor via magnetic coupling that is opposite to the residual high-frequency signal of the communication frequency band, thereby actively suppressing a high-frequency current flowing through the primary inductor.

2. The circuit according to claim 1, wherein the error sensing unit comprises a Hall sensor connected in series subsequent to the primary inductor, and the Hall sensor is configured to sense a residual high-frequency current flowing through the primary inductor as the residual high-frequency signal of the communication frequency band; and wherein the current generator further comprises:
a first ADC coupled to the Hall sensor and configured to detect an induced voltage from the Hall sensor;
a second ADC coupled to the secondary side inductor and configured to detect a reference voltage corresponding to a voltage across the primary inductor;
a decision and calculation unit configured to receive data from the first ADC and the second ADC; and
a current DAC controlled by the decision and calculation unit;
wherein the decision and calculation unit performs feedback control based on the reference voltage and the induced voltage, causing the current DAC to dynamically adjust a magnitude and a direction of the compensation current so as to cause the induced voltage to converge to a minimum value.

3. The circuit according to claim 1, wherein the error sensing unit comprises a sensing transformer and a series capacitor; wherein a primary side of the sensing transformer is connected in series with the power line path, and the series capacitor is coupled between a secondary side of the sensing transformer and the current generator, the series capacitor being configured to isolate a low-frequency power current and to couple and generate an induced voltage as the residual high-frequency signal of the communication frequency band; and wherein the current generator further comprises:
a first ADC coupled to the series capacitor and configured to detect the induced voltage;
a second ADC coupled to the secondary side inductor and configured to detect a reference voltage;
a decision and calculation unit configured to receive data from the first ADC and the second ADC; and
a current DAC controlled by the decision and calculation unit;
wherein the decision and calculation unit performs feedback control based on the reference voltage and the induced voltage, causing the current DAC to dynamically adjust a magnitude and a direction of the compensation current so as to cause the induced voltage to converge to a minimum value.

4. The circuit according to claim 3, further comprising a filter capacitor connected across an output end of the power line path to form an LC low-pass filter circuit with the primary inductor; wherein the compensation current is injected into the secondary side inductor via an isolation capacitor.

5. The circuit according to claim 4, wherein the power line path comprises a first power line and a second power line; and wherein the circuit comprises two independent sets of the primary inductor, the error sensing unit, and the current generator disposed on the first power line and the second power line, respectively, to form a symmetric filtering architecture for performing independent closed-loop impedance enhancement control on currents flowing through the first power line and the second power line.

6. The circuit according to claim 3, further comprising a differential mode filtering circuit and a common mode filtering circuit; the power line path comprises a first power line and a second power line; the sensing transformer comprises a first sensing transformer connected in series with the first power line, and a second sensing transformer connected in series with the second power line; and the current generator comprises a first current generator and a second current generator; wherein
the first current generator of the differential mode filtering circuit receives signals from the first sensing transformer and the second sensing transformer, performs a subtraction operation to detect a differential mode current, and controls enhancement of a differential mode inductor serving as the primary inductor based on the differential mode current; and
the second current generator of the common mode filtering circuit receives signals from the first sensing transformer and the second sensing transformer, performs an addition operation to detect a common mode current, and controls enhancement of a common mode inductor serving as the primary inductor based on the common mode current.

7. The circuit according to claim 6, wherein the first sensing transformer and the second sensing transformer are disposed on one side of the differential mode inductor and located before a first filter capacitor connected between the first power line and the second power line;
wherein the first filter capacitor is connected between the first power line and the second power line and disposed between the differential mode inductor and the common mode inductor, so as to ensure measurement of a complete differential mode current including that flowing through the first filter capacitor.

8. The circuit according to claim 6, wherein the second ADC comprises a summing amplifier, a sample and hold circuit, and a comparator and digital circuit; wherein the summing amplifier has four input terminals configured to receive signals from the first sensing transformer and the second sensing transformer to perform the addition or subtraction operation.

9. The circuit according to claim 8, wherein the summing amplifier has a feedback resistor connected between an output terminal and an inverting input terminal of the summing amplifier; wherein a resistance value of the feedback resistor is adjusted and controlled by a decision and calculation unit within the current generator to change an amplification value, thereby dynamically adjusting a voltage detection range.

10. The circuit according to claim 6, wherein: the differential mode filter circuit utilizes a single-side winding architecture, wherein a main inductor consists of a single-side winding inductor connected in series to the first power line (B1); and the first sensing transformer and the second sensing transformer are disposed on the first power line and the second power line, respectively, and are arranged before a filter capacitor.
